# EUROPEAN PATENT APPLICATION

(11) **EP 4 492 454 A1**
(43) Date of publication of application: **15.01.2025**
(21) Application number: 23788312.9
(22) Date of filing: 10.04.2023
(51) Int. Cl.: H01L 23/473, H05K 7/20, H01M 10/613, H01M 10/625, H01M 10/6554, H01M 10/6556

(54) **COOLER**

(30) Priority: 11.04.2022 JP 2022065120
(71) Applicant: Sanoh Industrial Co., Ltd., Koga-shi, Ibaraki 306-0041 (JP)
(72) Inventor: YAMAZAKI, Nobushi, Koga-shi, Ibaraki 306-0041 (JP); SHIBASAKI, Yoshitaka, Koga-shi, Ibaraki 306-0041 (JP)
(74) Representative: Grünecker Patent- und Rechtsanwälte PartG mbB
(86) International application number: PCT/JP2023/014584
(87) International publication number: WO 2023/199894

(57) **Abstract**

A cooler has a coolant passage. The cooler includes a cooling plate portion having a plurality of partition walls extending in a longitudinal direction and partitioning the coolant passage in a width direction orthogonal to the longitudinal direction, and an opening that opens the coolant passage in a first longitudinal direction that is one direction of the longitudinal direction and a first height direction that is one direction of a height direction orthogonal to the longitudinal direction and the width direction; and a lid portion joined to the cooling plate portion so as to close the opening of the cooling plate portion. A joint surface of the cooling plate portion with the lid portion is directed further toward the first height direction side than toward the longitudinal direction.

## Description

### Technical Field

One aspect of the present invention relates to a cooler that cools a battery or the like.

### Background Art

Patent Literature 1 describes a cooler that cools a battery or the like. The cooler includes a flat cooling plate having a coolant passage along a longitudinal direction, and a pair of upper lid bodies joined to the cooling plate and having a coolant inflow port and a coolant outflow port communicating with the coolant passage. At both ends of the cooling plate in the longitudinal direction, a pair of notches are formed to open the upper and longitudinal end portions while leaving both wall portions in a width direction. The pair of upper lid bodies are joined to the pair of notches by brazing.

### Citation List

### Patent Literature

Patent Literature 1: Japanese Patent No. 6494134

### Summary of Invention

### Technical Problem

The cooling plate of the cooler described in Patent Literature 1 is formed in a flat shape by an upper piece, a lower piece, and a pair of both side walls. An upper surface of the upper piece and both end surfaces of the lower piece and the pair of both side walls in the longitudinal direction become joint surfaces of the cooling plate joined to the pair of upper lid bodies. However, while the upper surface of the upper piece is a horizontal surface, both end surfaces of the lower piece and the pair of both side walls in the longitudinal direction are vertical surfaces. For this reason, when the cooling plate and the pair of upper lid bodies are brazed, a brazing material is likely to fall off from both end surfaces of the lower piece and the pair of both side walls in the longitudinal direction which are vertical surfaces. For this reason, a holder for holding the brazing material is required, and there is a problem that manufacturing cost increases.

Here, it is also conceivable to join the cooling plate and the pair of upper lid bodies by welding. However, in the welding to the upper surface of the upper piece which is a horizontal surface and the welding to both end surfaces of the lower piece and the pair of both side walls in the longitudinal direction which are vertical surfaces, welding directions are directions orthogonal to each other. That is, the upper surface of the upper piece which is a horizontal surface needs to be welded from a vertical direction, and both end surfaces of the lower piece and the pair of both side walls in the longitudinal direction which are vertical surfaces need to be welded from a horizontal direction. For this reason, there is a problem that a large welding facility is required and the manufacturing cost increases.

Therefore, an object of one aspect of the present invention is to provide a cooler capable of reducing manufacturing cost.

### Solution to Problem

A cooler according to one aspect of the present invention is as follows.
[1] A cooler having a coolant passage, the cooler including: a cooling plate portion having a plurality of partition walls extending in a longitudinal direction and partitioning the coolant passage in a width direction orthogonal to the longitudinal direction, and an opening that opens the coolant passage in a first longitudinal direction which is one direction of the longitudinal direction and a first height direction which is one direction of a height direction orthogonal to the longitudinal direction and the width direction; and a lid portion joined to the cooling plate portion so as to close the opening of the cooling plate portion, in which a joint surface of the cooling plate portion with the lid portion is directed further toward the first height direction side than toward the longitudinal direction.
   In the cooler of [1], the lid portion is joined to the cooling plate portion to close the opening of the cooling plate portion. Here, since the opening opens the coolant passage in the first longitudinal direction and the first height direction, a portion displaced in the height direction exists on the joint surface of the cooling plate portion. However, the joint surface of the cooling plate portion is directed further toward the first height direction side than toward the longitudinal direction. Therefore, when the cooling plate portion and the lid portion are joined by brazing, a brazing material is less likely to fall off from the joint surface. When the cooling plate portion and the lid portion are joined by welding, a welding direction does not need to be directed in the longitudinal direction. Accordingly, manufacturing cost can be reduced.
[2] The cooler described in [1], in which the joint surface has an inclined surface directed in a second height direction opposite to the first height direction as the inclined surface goes toward the first longitudinal direction.
   In the cooler of [2], since the joint surface has the inclined surface directed in the second direction as the inclined surface goes toward the first longitudinal direction, the joint surface can be directed further toward the first height direction side than toward the longitudinal direction in a portion of the joint surface displaced in the height direction.
[3] The cooler described in [2], in which the joint surface is formed by a horizontal surface extending in the longitudinal direction and the width direction, and the inclined surface.
   In the cooler of [3], since the joint surface is formed by the horizontal surface and the inclined surface, the joint surface can be directed further toward the first height direction side than toward the longitudinal direction.
[4] The cooler described in any one of [1] to [3], in which the joint surface does not have a vertical surface extending in the height direction.
   In the cooler of [4], since the joint surface does not have the vertical surface, when the cooling plate portion and the lid portion are joined by brazing, the brazing material is less likely to fall off from the joint surface, and when the cooling plate portion and the lid portion are joined by welding, it is not necessary to direct a welding direction in the longitudinal direction.
[5] The cooler described in any one of [1] to [4], in which the cooling plate portion has a bottom wall portion extending in the longitudinal direction and the width direction, an upper wall portion extending in the longitudinal direction and the width direction and facing the bottom wall portion in the height direction, and a pair of side wall portions coupled to the bottom wall portion and the upper wall portion and facing each other in the width direction, and the joint surface is formed on the bottom wall portion, the upper wall portion, and the pair of side wall portions.
   In the cooler of [5], the cooling plate portion has the bottom wall portion, the upper wall portion, and the pair of side wall portions, and the joint surface is formed on the bottom wall portion, the upper wall portion, and the pair of side wall portions. Therefore, the coolant passage partitioned by the plurality of partition walls can be appropriately formed, and the opening that opens the coolant passage can be appropriately closed by the lid portion.
[6] The cooler described in [5], in which the joint surface is formed by an upper wall upper surface which is a surface of the upper wall portion on a side opposite to the bottom wall portion, an upper wall end surface which is an end surface of the upper wall portion in the first longitudinal direction, side wall end surfaces which are end surfaces of the pair of side wall portions in the first longitudinal direction, and a bottom wall upper surface which is a surface of the bottom wall portion on the upper wall portion side, the joint surface formed on the upper wall upper surface and the bottom wall upper surface is a horizontal surface extending in the longitudinal direction and the width direction, and the joint surface formed on the upper wall end surface and the side wall end surfaces is an inclined surface directed in a second height direction opposite to the first height direction as the inclined surface goes toward the first longitudinal direction.
   In the cooler of [6], since the joint surface is formed by the horizontal surface and the inclined surface, the joint surface can be directed further toward the first height direction side than toward the longitudinal direction.
[7] The cooler described in [5], in which the joint surface is formed by an upper wall upper surface which is a surface of the upper wall portion on a side opposite to the bottom wall portion, an upper wall end surface which is an end surface of the upper wall portion in the first longitudinal direction, side wall end surfaces which are end surfaces of the pair of side wall portions in the first longitudinal direction, and a bottom wall end surface which is an end surface of the bottom wall portion in the first longitudinal direction, the joint surface formed on the upper wall upper surface is a horizontal surface extending in the longitudinal direction and the width direction, and the joint surface formed on the upper wall end surface, the side wall end surfaces, and the bottom wall end surface is an inclined surface directed in a second height direction opposite to the first height direction as the inclined surface goes toward the first longitudinal direction.
   In the cooler of [7], since the joint surface is formed by the horizontal surface and the inclined surface, the joint surface can be directed further toward the first height direction side than toward the longitudinal direction.
[8] The cooler described in any one of [5] to [7], in which partition wall end surfaces which are end surfaces of the plurality of partition walls in the first longitudinal direction are formed at same positions as side wall end surfaces which are end surfaces of the pair of side wall portions in the first longitudinal direction when viewed from the width direction.
   In the cooler of [8], since the partition wall end surfaces are formed at the same positions as the side wall end surfaces when viewed from the width direction, the cooling plate portion can be easily manufactured.
[9] The cooler described in any one of [1] to [8], in which partition wall end surfaces which are end surfaces of the plurality of partition walls in the first longitudinal direction are inclined surfaces directed in second height direction opposite to the first height direction as the inclined surfaces go toward the first longitudinal direction.
   In the cooler of [9], since the partition wall end surfaces of the plurality of partition walls in the first longitudinal direction are inclined surfaces, an opening area of partitioned coolant passages formed by partitioning the coolant passage by the plurality of partition walls can be increased. As a result, a pressure loss of the coolant can be reduced. In addition, it is possible to suppress a rapid change in the pressure loss of the coolant due to the plurality of partition walls.
[10] The cooler described in any one of [1] to [9], further including an attachment portion for attaching the cooler to an external device, in which the attachment portion is located on an opposite side of the coolant passage with respect to the joint surface.

In the cooler of [10], since the attachment portion is located on the opposite side of the coolant passage with respect to the joint surface, it is possible to suppress blocking of the coolant passage from being obstructed by the attachment portion and to suppress complication of a shape of the joint surface.

### Advantageous Effects of Invention

According to one aspect of the present invention, manufacturing cost can be reduced.

### Brief Description of Drawings

FIG. 1 is a perspective view illustrating a cooler of a first embodiment.
FIG. 2 is a cross-sectional view taken along line II-II illustrated in FIG. 1.
FIG. 3 is a side view illustrating an end portion of the cooler in a first longitudinal direction.
FIG. 4 is a side view illustrating the end portion of the cooler in a second longitudinal direction.
FIG. 5 is a plan view illustrating the end portion of the cooler in the first longitudinal direction.
FIG. 6 is a plan view illustrating the end portion of the cooler in the second longitudinal direction.
FIG. 7 is a perspective view illustrating a state of the end portion of the cooler in the first longitudinal direction, before a cooling plate portion and lid portion are joined to each other.
FIG. 8 is a perspective view illustrating a state of the end portion of the cooler in the second longitudinal direction, before the cooling plate portion and the lid portion are joined to each other.
FIG. 9 is a plan view illustrating the end portion of the cooling plate portion in the first longitudinal direction and the second longitudinal direction.
FIG. 10 is a front view illustrating the end portion of the cooling plate portion in the first longitudinal direction and the second longitudinal direction.
FIG. 11 is a side view illustrating the end portion of the cooling plate portion in the first longitudinal direction and the second longitudinal direction.
FIG. 12 is a perspective view illustrating an end portion of a cooler according to a second embodiment in the first longitudinal direction and the second longitudinal direction.
FIG. 13 is a cross-sectional view taken along line XIII-XIII illustrated in FIG. 12.
FIG. 14 is a perspective view illustrating a state of the end portion of the cooler in the first longitudinal direction, before the cooling plate portion and the lid portion are joined to each other.
FIG. 15 is a perspective view illustrating the state of the end portion of the cooler in the second longitudinal direction, before the cooling plate portion and the lid portion are joined to each other.
FIG. 16 is a plan view illustrating the end portion of the cooling plate portion in the first longitudinal direction and the second longitudinal direction.
FIG. 17 is a front view illustrating the end portion of the cooling plate portion in the first longitudinal direction and the second longitudinal direction.
FIG. 18 is a side view illustrating the end portion of the cooling plate portion in the first longitudinal direction and the second longitudinal direction.
FIG. 19 is a plan view illustrating a cooler of a third embodiment.
FIG. 20 is a perspective view illustrating a state of the end portion of the cooler in the first longitudinal direction, before the cooling plate portion and the lid portion are joined to each other.
FIG. 21 is a perspective view illustrating the state of the end portion of the cooler in the second longitudinal direction, before the cooling plate portion and the lid portion are joined to each other.
FIG. 22 is a side view illustrating a cooler of a modification.
FIG. 23 is a perspective view illustrating a cooler of a reference example.

### Description of Embodiments

Hereinafter, a cooler according to embodiments will be described with reference to the drawings. The cooler according to the present embodiment cools a body to be cooled. The body to be cooled is not particularly limited, and can be, for example, a battery mounted on a vehicle such as an electric vehicle. In the drawings, the same or corresponding elements are denoted by the same reference numerals, and redundant description will be omitted.

### [First Embodiment]

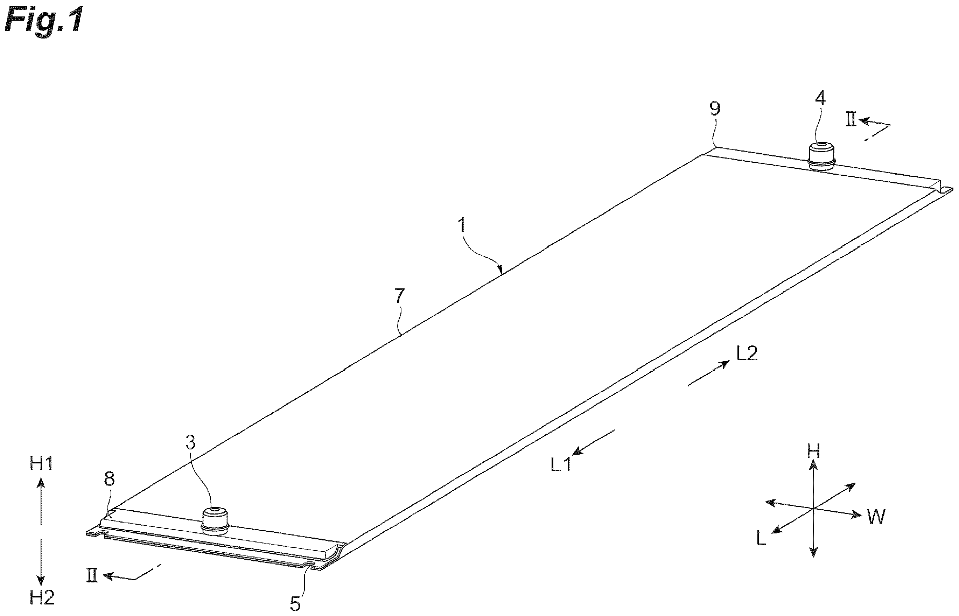

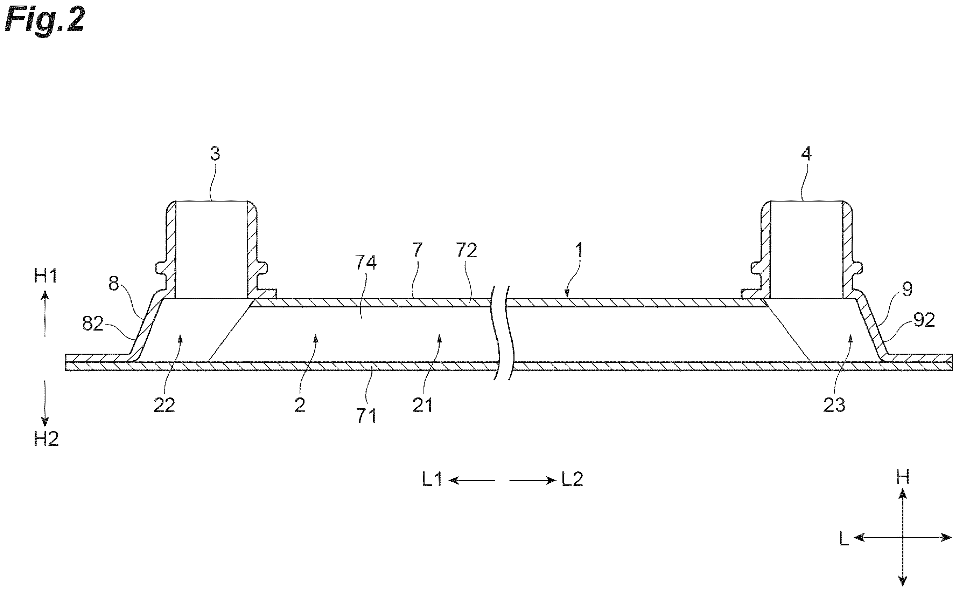

FIG. 1 is a perspective view illustrating a cooler according to a first embodiment. FIG. 2 is a cross-sectional view taken along line II-II illustrated in FIG. 1. As illustrated in FIGS. 1 and 2, a cooler 1 according to the present embodiment is formed in a flat shape so as to increase a contact area with a body to be cooled. That is, the cooler 1 extends in a longitudinal direction L and a width direction W orthogonal to the longitudinal direction L, and is flattened in a height direction H orthogonal to the longitudinal direction L and the width direction W. A cooling plate portion 7 is formed to be longer in the longitudinal direction L than in the width direction W. One direction of the longitudinal direction L is referred to as a first longitudinal direction L1, and the other direction of the longitudinal direction L is referred to as a second longitudinal direction L2. The second longitudinal direction L2 is a direction opposite to the first longitudinal direction L1. One direction in the height direction H is referred to as a first height direction H1, and the other direction in the height direction H is referred to as a second height direction H2. The second height direction H2 is a direction opposite to the first height direction H1.

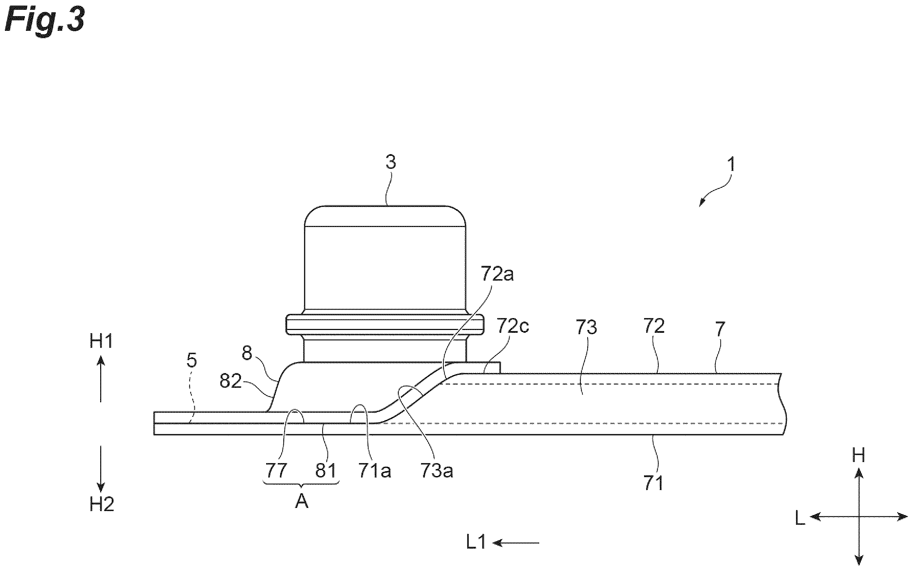

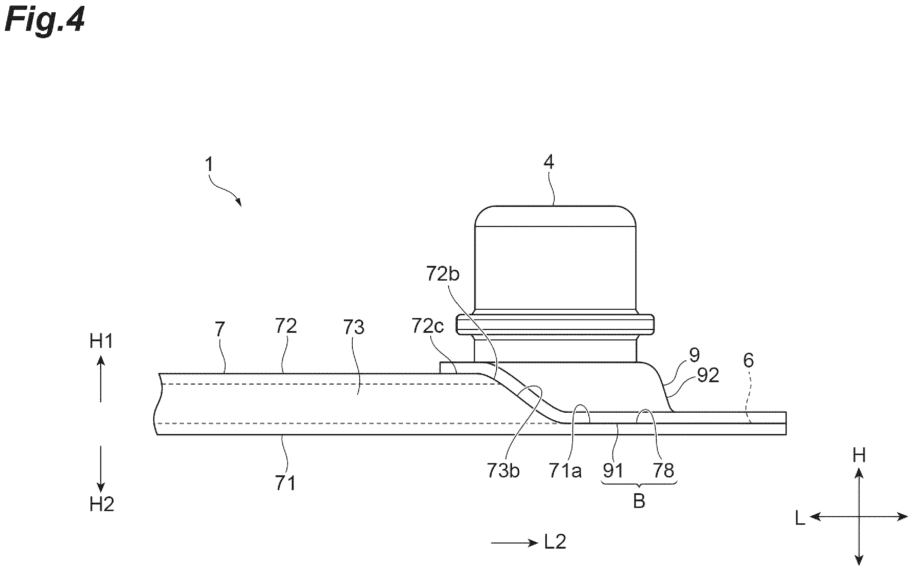

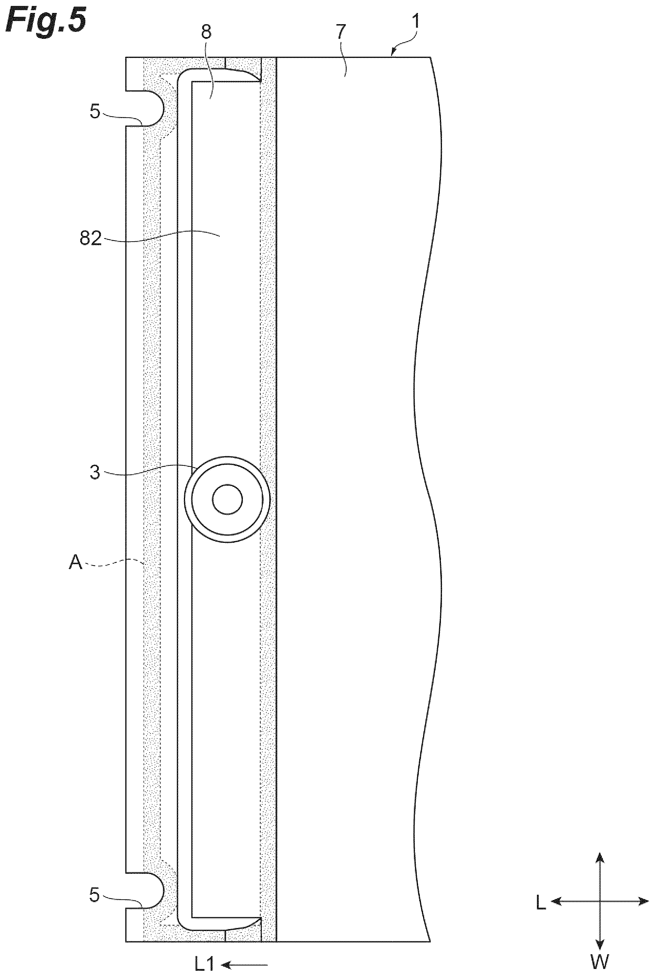

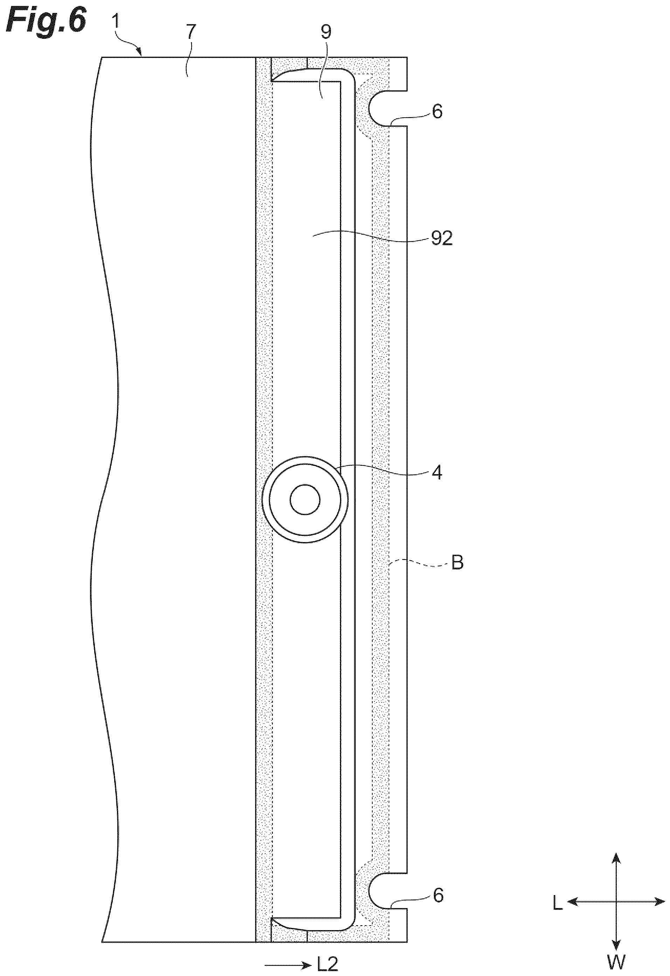

FIG. 3 is a side view illustrating an end portion of the cooler in the first longitudinal direction. FIG. 4 is a side view illustrating the end portion of the cooler in the second longitudinal direction. FIG. 5 is a plan view illustrating the end portion of the cooler in the first longitudinal direction. FIG. 6 is a plan view illustrating the end portion of the cooler in the second longitudinal direction. As illustrated in FIGS. 1 to 6, the cooler 1 includes a coolant passage 2, a first port 3, a second port 4, first attachment portions 5, and second attachment portions 6.

The coolant passage 2 is a passage (space) through which a coolant for cooling the body to be cooled flows. The first port 3 and the second port 4 communicate with the coolant passage 2 and supply or discharge the coolant to or from the coolant passage 2. The first port 3 is located at an end portion of the cooler 1 in the first longitudinal direction L1. The second port 4 is located at an end portion of the cooler 1 in the second longitudinal direction L2. Therefore, the coolant is supplied from one of the first port 3 and the second port 4 to the coolant passage 2, flows through the coolant passage 2 in the longitudinal direction L, and is discharged from the other of the first port 3 and the second port 4. The coolant absorbs heat from the cooler 1 when flowing through the coolant passage 2 to cool the body to be cooled coupled to the cooler 1.

The first attachment portion 5 and the second attachment portion 6 are portions for attaching the cooler 1 to an external device (not illustrated). The first attachment portion 5 is located at the end portion of the cooler 1 in the first longitudinal direction L1. The second attachment portion 6 is located at the end portion of the cooler 1 in the second longitudinal direction L2. The first attachment portion 5 and the second attachment portion 6 are, for example, through-holes into which bolts (not illustrated) for attaching the cooler 1 to the external device are inserted. The external device may be a body to be cooled that is a cooling target of the cooler 1.

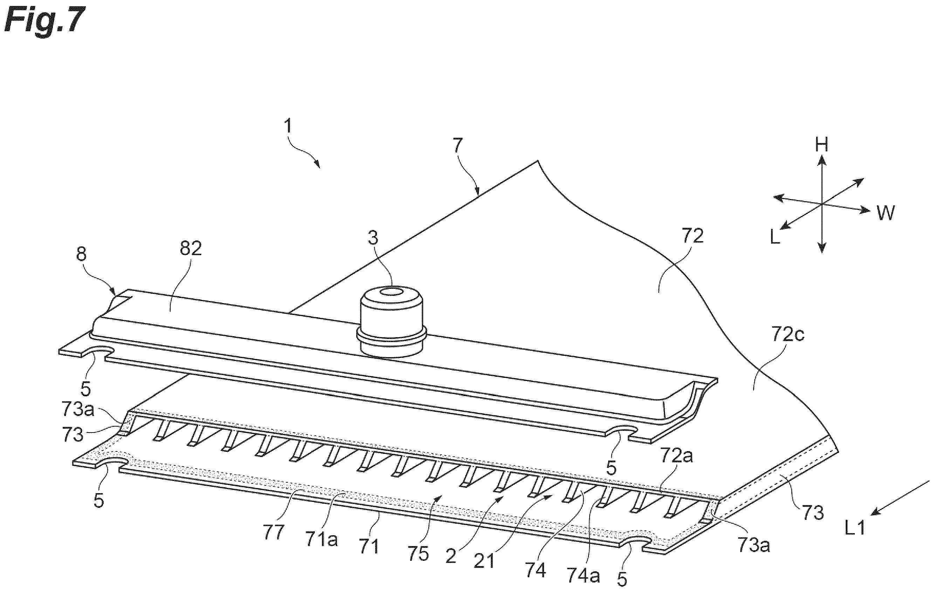

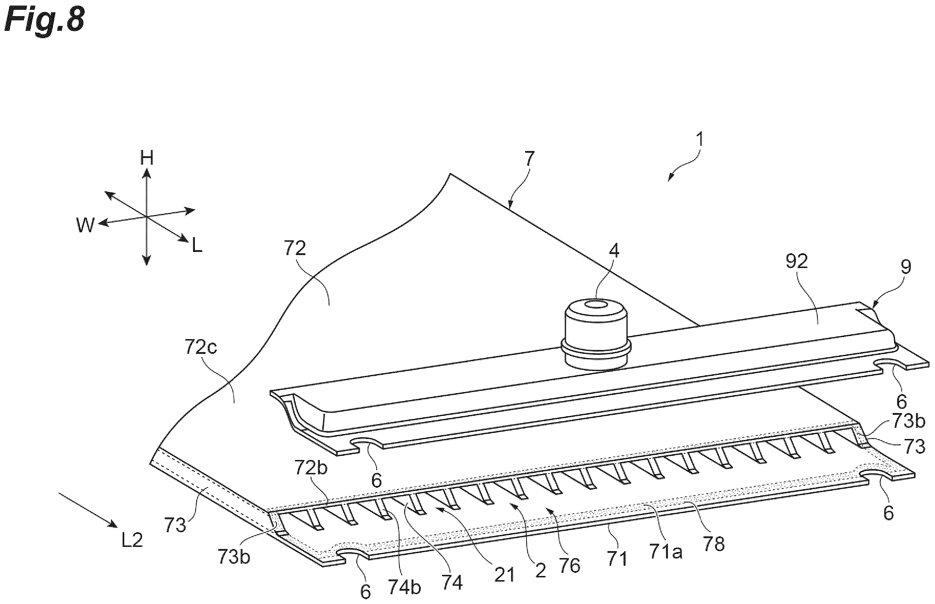

FIG. 7 is a perspective view illustrating a state of the end portion of the cooler in the first longitudinal direction, before the cooling plate portion and the lid portion are joined to each other. FIG. 8 is a perspective view illustrating a state of the end portion of the cooler in the second longitudinal direction, before the cooling plate portion and the lid portion are joined to each other. As illustrated in FIGS. 1 to 8, the cooler 1 includes a cooling plate portion 7, and first lid portions 8 and second lid portions 9 joined to the cooling plate portion 7.

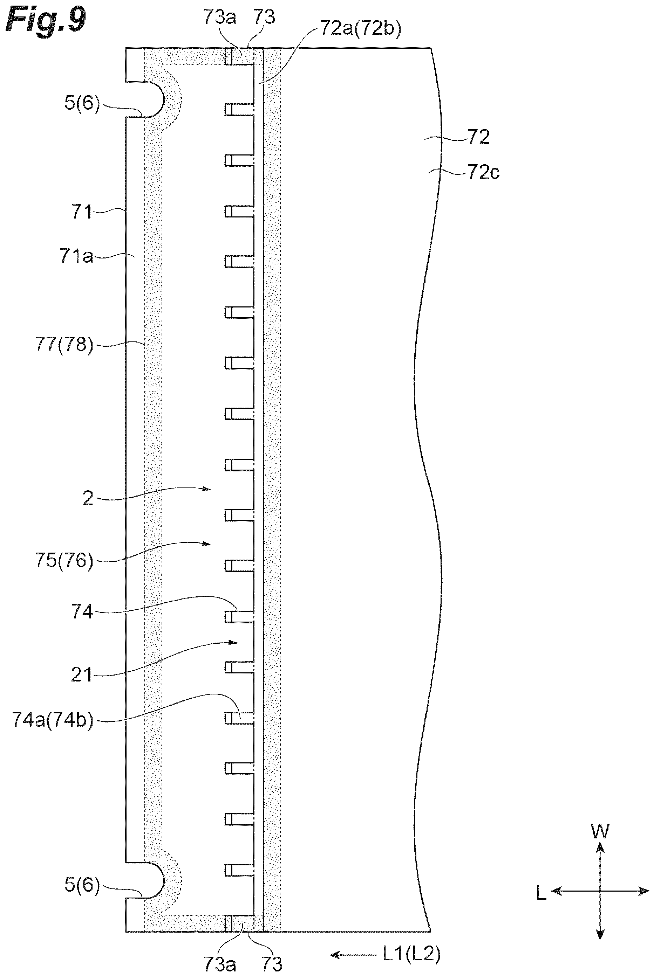

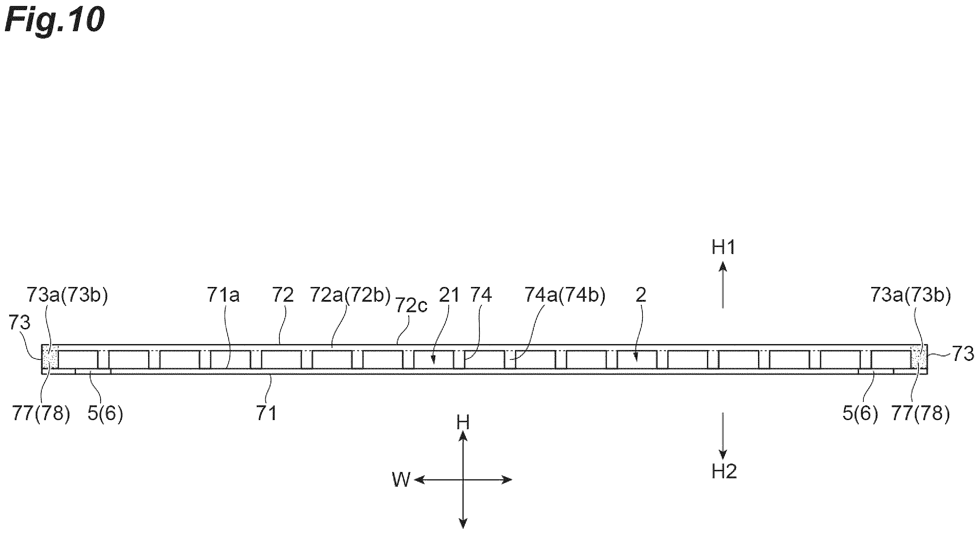

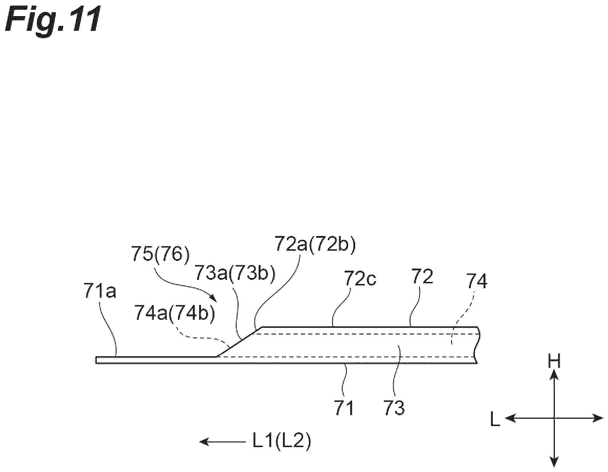

FIG. 9 is a plan view illustrating the end portion of the cooling plate portion in the first longitudinal direction and the second longitudinal direction. FIG. 10 is a front view illustrating the end portion of the cooling plate portion in the first longitudinal direction and the second longitudinal direction. FIG. 11 is a side view illustrating the end portion of the cooling plate portion in the first longitudinal direction and the second longitudinal direction. Note that reference numerals in parentheses in FIGS. 9 to 11 indicate reference numerals of end portions of the cooling plate portion in the second longitudinal direction. As illustrated in FIGS. 1 to 11, the cooling plate portion 7 forms a main body of the cooler 1. The cooling plate portion 7 includes a bottom wall portion 71, an upper wall portion 72, a pair of side wall portions 73 and 73, a plurality of partition walls 74, a first opening 75, and a second opening 76.

The bottom wall portion 71 is a portion which forms a bottom wall of the cooler 1 and is brought into contact with the body to be cooled. The bottom wall portion 71 is formed in a substantially flat plate extending in the longitudinal direction L and the width direction W. A part of the first attachment portion 5 is formed at an end portion of the bottom wall portion 71 in the first longitudinal direction L1, and a part of the second attachment portion 6 is formed at an end portion of the bottom wall portion 71 in the second longitudinal direction L2.

The upper wall portion 72 is a portion forming an upper wall of the cooler 1. The upper wall portion 72 is formed in a substantially flat plate shape extending in the longitudinal direction L and the width direction W. The upper wall portion 72 is disposed so as to face the bottom wall portion 71 in the height direction H.

The pair of side wall portions 73 and 73 are portions forming a pair of side walls of the cooler 1. The pair of side wall portions 73 and 73 are formed in a substantially flat plate shape extending in the longitudinal direction L and the height direction H. The pair of side wall portions 73 and 73 are disposed so as to face each other in the width direction W, and are coupled to both end portions of the bottom wall portion 71 and the upper wall portion 72 in the width direction W.

The plurality of partition walls 74 extend in the longitudinal direction L and partition the coolant passage 2 in the width direction W. That is, the plurality of partition walls 74 extending in the longitudinal direction L are arranged in the width direction W. Each of the plurality of partition walls 74 is formed in a substantially flat plate shape extending in the longitudinal direction L and the height direction H, and is coupled to the bottom wall portion 71 and the upper wall portion 72. In the cooling plate portion 7, the coolant passage 2 is partitioned into a plurality of partitioned coolant passages 21 by the plurality of partition walls 74. The plurality of partitioned coolant passages 21 extend in the longitudinal direction L and are arranged in the width direction W. Of the plurality of partitioned coolant passages 21, partitioned coolant passages 21 located at both ends in the width direction W are formed by the bottom wall portion 71, the upper wall portion 72, the side wall portion 73, and the partition wall 74, and the other partitioned coolant passages 21 are formed by the bottom wall portion 71, the upper wall portion 72, and the pair of adjacent partition walls 74.

As illustrated in FIGS. 7 to 11, the first opening 75 opens the coolant passage 2 in the first longitudinal direction L1 and the first height direction H1 at the end portion of the cooling plate portion 7 in the first longitudinal direction L1. The second opening 76 opens the coolant passage 2 in the second longitudinal direction L2 and the first height direction H1 at the end portion of the cooling plate portion 7 in the second longitudinal direction L2. The first opening 75 and the second opening 76 are formed by the bottom wall portion 71, the upper wall portion 72, and the pair of side wall portions 73 and 73. The first opening 75 and the second opening 76 are formed, for example, by cutting out the upper wall portion 72, the pair of side wall portions 73 and 73, and the plurality of partition walls 74.

In the first opening 75, a distal end of the upper wall portion 72 in the first longitudinal direction L1 is located on the second longitudinal direction L2 side with respect to a distal end of the bottom wall portion 71 in the first longitudinal direction L1, so that the coolant passage 2 is opened in the first height direction H1. In the first opening 75, the cooling plate portion 7 is not provided on the first longitudinal direction L1 side of the coolant passage 2, so that the coolant passage 2 is opened in the first longitudinal direction L1.

In the second opening 76, a distal end of the upper wall portion 72 in the second longitudinal direction L2 is located on the first longitudinal direction L1 side with respect to a distal end of the bottom wall portion 71 in the second longitudinal direction L2, so that the coolant passage 2 is opened in the first height direction H1. In the second opening 76, the cooling plate portion 7 is not provided on the second longitudinal direction L2 side of the coolant passage 2, so that the coolant passage 2 is opened in the second longitudinal direction L2.

As illustrated in FIGS. 1 to 3, 5, 7, and 9 to 11, the first lid portion 8 is joined to the cooling plate portion 7 so as to close the first opening 75. A portion where the cooling plate portion 7 and the first lid portion 8 are joined is referred to as a first joint portion A. At the first joint portion A, a first joint surface 77 of the cooling plate portion 7 and a joint surface 81 of the first lid portion 8 are joined. The first joint surface 77 is a joint surface of the cooling plate portion 7 with the first lid portion 8, and does not include a surface not joined with the first lid portion 8. The joint surface 81 is a joint surface of the first lid portion 8 with the cooling plate portion 7, and does not include a surface not joined with the cooling plate portion 7. Joining of the first lid portion 8 to the cooling plate portion 7 is not particularly limited, but can be performed by, for example, brazing, welding, or the like. In the drawings, the first joint portion A, the first joint surface 77, and the joint surface 81 are indicated by fine dot hatching.

The first lid portion 8 has the first port 3 described above and a chamber forming portion 82. The chamber forming portion 82 forms a first chamber 22 disposed between the first port 3 and the plurality of partitioned coolant passages 21. The first chamber 22 is a space that is located on the first longitudinal direction L1 side of the plurality of partitioned coolant passages 21, communicates with the plurality of partitioned coolant passages 21, and communicates with the first port 3. The first chamber 22 forms a part of the coolant passage 2, and distributes or merges a coolant between the first port 3 and the plurality of partitioned coolant passages 21.

Apart of the first attachment portion 5 is formed at an end portion of the first lid portion 8 in the first longitudinal direction L1. The first attachment portion 5 is formed by a portion where the bottom wall portion 71 of the cooling plate portion 7 and the first lid portion 8 overlap each other.

The joint surface 81 of the first lid portion 8 surrounds the chamber forming portion 82 in order to close the first opening 75. The joint surface 81 has a shape corresponding to the first joint surface 77 of the cooling plate portion 7, that is, a shape along the first joint surface 77 of the cooling plate portion 7.

The first joint surface 77 of the cooling plate portion 7 surrounds the first opening 75 in order to close the first opening 75. The first joint surface 77 is formed on an upper wall upper surface 72c which is a surface of the upper wall portion 72 on a side (first height direction H1 side) opposite to the bottom wall portion 71, a first upper wall end surface 72a which is an end surface of the upper wall portion 72 in the first longitudinal direction L1, first side wall end surfaces 73a and 73a which are end surfaces of the pair of side wall portions 73 and 73 in the first longitudinal direction L1, and a bottom wall upper surface 71a which is a surface of the bottom wall portion 71 on the upper wall portion 72 side (first height direction H1 side). The first joint surface 77 is formed by a horizontal surface extending in the longitudinal direction L and the width direction W and an inclined surface directed in the second height direction H2 as it goes toward the first longitudinal direction L1, and does not have a vertical surface extending in the height direction H. Therefore, the first joint surface 77 is directed further toward the first height direction H1 side (the upper wall portion 72 side with respect to the bottom wall portion 71) than toward the longitudinal direction L. That is, the entire first joint surface 77 surrounding the first opening 75 is directed further toward the first height direction H1 side than toward the longitudinal direction L. In addition, the first joint surface 77 is directed further toward the first height direction H1 side than toward the longitudinal direction L and goes around the first opening 75 when viewed from the first height direction H1 (surrounds an entire circumference of the first opening 75 when viewed from the first height direction H1). Note that the inclined surface is not limited to an inclined surface extending in a planar shape, and may be an inclined surface that is inclined while being bent at one or a plurality of places, or may be an inclined surface that is inclined while being curved.

Specifically, the upper wall upper surface 72c and the bottom wall upper surface 71a are horizontal surfaces extending in the longitudinal direction L and the width direction W. The first upper wall end surface 72a is an inclined surface directed in the second height direction H2 as it goes toward the first longitudinal direction L1. The first side wall end surfaces 73a and 73a are coupled to the first upper wall end surface 72a and the bottom wall upper surface 71a, and are inclined surfaces directed in the second height direction H2 as it goes toward the first longitudinal direction L1. An inclination angle of the first upper wall end surface 72a and an inclination angle of the first side wall end surfaces 73a and 73a can be the same. In this case, the first upper wall end surface 72a and the first side wall end surfaces 73a and 73a are flush with each other.

First partition wall end surfaces 74a which are end surfaces of the plurality of partition walls 74 in the first longitudinal direction L1 are inclined surfaces directed in the second height direction H2 as it goes toward the first longitudinal direction L1. The first partition wall end surfaces 74a are formed at the same positions as the first side wall end surfaces 73a and 73a when viewed from the width direction W. That is, an inclination angle of the first partition wall end surfaces 74a is the same as the inclination angle of the first side wall end surfaces 73a and 73a.

The first joint surface 77 of the cooling plate portion 7 is formed on the upper wall upper surface 72c which is a horizontal surface, the first upper wall end surface 72a which is an inclined surface, the first side wall end surfaces 73a and 73a which are inclined surfaces, and the bottom wall upper surface 71a which is a horizontal surface.

The first joint portion A (the first joint surface 77 and the joint surface 81) may be formed at any position of the upper wall upper surface 72c, the first upper wall end surface 72a, the first side wall end surfaces 73a and 73a, and the bottom wall upper surface 71a, but it is preferable that the first attachment portion 5 be formed so as to be located on the opposite side of the coolant passage 2 with respect to the first joint portion A. In this case, the first joint portion A may be formed at a position spaced apart from the first attachment portion 5, or may be formed at a position surrounding a part of the first attachment portion 5. In the drawings, as an example, a case where the first joint portion A is formed at a position surrounding a part of the first attachment portion 5 is indicated.

As illustrated in FIGS. 1, 2, 4, 6, and 8 to 11, the second lid portion 9 is joined to the cooling plate portion 7 so as to close the second opening 76. A portion where the cooling plate portion 7 and the second lid portion 9 are joined is referred to as a second joint portion B. The cooling plate portion 7 and the second lid portion 9 are joined at the second joint portion B. In the second joint portion B, a second joint surface 78 of the cooling plate portion 7 and a joint surface 91 of the second lid portion 9 are joined. The second joint surface 78 is a joint surface of the cooling plate portion 7 with the second lid portion 9, and does not include a surface not joined with the second lid portion 9. The joint surface 91 is a joint surface of the second lid portion 9 with the cooling plate portion 7, and does not include a surface not joined with the cooling plate portion 7. Joining of the second lid portion 9 to the cooling plate portion 7 is not particularly limited, but can be performed by, for example, brazing, welding, or the like. In the drawings, the second joint portion B, the second joint surface 78, and the joint surface 91 are indicated by fine dot hatching.

The second lid portion 9 has the second port 4 described above and a chamber forming portion 92. The chamber forming portion 92 forms a second chamber 23 disposed between the second port 4 and the plurality of partitioned coolant passages 21. The second chamber 23 is a space that is located on the second longitudinal direction L2 side of the plurality of partitioned coolant passages 21, communicates with the plurality of partitioned coolant passages 21, and communicates with the second port 4. The second chamber 23 forms a part of the coolant passage 2, and distributes or merges a coolant between the second port 4 and the plurality of partitioned coolant passages 21.

A part of the second attachment portion 6 is formed at an end portion of the second lid portion 9 in the second longitudinal direction L2. The second attachment portion 6 is formed by a portion where the bottom wall portion 71 of the cooling plate portion 7 and the second lid portion 9 overlap each other.

The joint surface 91 of the second lid portion 9 surrounds the chamber forming portion 92 in order to close the second opening 76. The joint surface 91 has a shape corresponding to the second joint surface 78 of the cooling plate portion 7, that is, a shape along the second joint surface 78 of the cooling plate portion 7.

The second joint surface 78 of the cooling plate portion 7 surrounds the second opening 76 in order to close the second opening 76. The second joint surface 78 is formed on the upper wall upper surface 72c, a second upper wall end surface 72b which is an end surface of the upper wall portion 72 in the second longitudinal direction L2, second side wall end surfaces 73b and 73b which are end surfaces of the pair of side wall portions 73 and 73 in the second longitudinal direction L2, and the bottom wall upper surface 71a. The second joint surface 78 is formed by a horizontal surface extending in the longitudinal direction L and the width direction W and an inclined surface directed in the second height direction H2 as it goes toward the second longitudinal direction L2, and does not have a vertical surface extending in the height direction H. Therefore, the second joint surface 78 is directed further toward the first height direction H1 side than toward the longitudinal direction L. That is, the entire second joint surface 78 surrounding the second opening 76 is directed further toward the first height direction H1 side than toward the longitudinal direction L. In addition, the second joint surface 78 is directed further toward the first height direction H1 side than toward the longitudinal direction L and goes around the second opening 76 when viewed from the first height direction H1 (surrounds an entire circumference of the second opening 76 when viewed from the first height direction H1).

Specifically, the upper wall upper surface 72c and the bottom wall upper surface 71a are horizontal surfaces extending in the longitudinal direction L and the width direction W. The second upper wall end surface 72b is an inclined surface directed in the second height direction H2 as it goes toward the second longitudinal direction L2. The second side wall end surfaces 73b and 73b are coupled to the second upper wall end surface 72b and the bottom wall upper surface 71a, and are inclined surfaces directed in the second height direction H2 as it goes toward the second longitudinal direction L2. An inclination angle of the second upper wall end surface 72b and an inclination angle of the second side wall end surfaces 73b and 73b can be the same. In this case, the second upper wall end surface 72b and the second side wall end surfaces 73b and 73b are flush with each other.

The second partition wall end surfaces 74b which are end surfaces of the plurality of partition walls 74 in the second longitudinal direction L2 are inclined surfaces directed in the second height direction H2 as it goes toward the second longitudinal direction L2. The second partition wall end surfaces 74b are formed at the same positions as the second side wall end surfaces 73b and 73b when viewed from the width direction W. That is, an inclination angle of the second partition wall end surfaces 74b is the same as the inclination angle of the second side wall end surfaces 73b and 73b.

The second joint surface 78 of the cooling plate portion 7 is formed on the upper wall upper surface 72c which is a horizontal surface, the second upper wall end surface 72b which is an inclined surface, the second side wall end surfaces 73b and 73b which are inclined surfaces, and the bottom wall upper surface 71a which is a horizontal surface.

The second joint portion B (the second joint surface 78 and the joint surface 91) may be formed at any position of the upper wall upper surface 72c, the second upper wall end surface 72b, the second side wall end surfaces 73b and 73b, and the bottom wall upper surface 71a, but it is preferable that the second attachment portion 6 be formed so as to be located on the opposite side of the coolant passage 2 with respect to the second joint portion B. In this case, the second joint portion B may be formed at a position spaced apart from the second attachment portion 6, or may be formed at a position surrounding a part of the second attachment portion 6. In the drawings, as an example, a case where the second joint portion B is formed at a position surrounding a part of the second attachment portion 6 is indicated.

As described above, in the cooler 1 according to the present embodiment, the first opening 75 and the second opening 76 of the cooling plate portion 7 are closed by joining the first lid portion 8 and the second lid portion 9 to the cooling plate portion 7. Here, since the first opening 75 opens the coolant passage 2 in the first longitudinal direction L1 and the first height direction H1, a portion displaced in the height direction H exists on the first joint surface 77 of the cooling plate portion 7. Since the second opening 76 opens the coolant passage 2 in the second longitudinal direction L2 and the first height direction H1, a portion displaced in the height direction H exists on the second joint surface 78 of the cooling plate portion 7. However, the first joint surface 77 and the second joint surface 78 of the cooling plate portion 7 are directed further toward the first height direction H1 side than toward the longitudinal direction L. Therefore, when the cooling plate portion 7 is joined to the first lid portion 8 and the second lid portion 9 by brazing, the brazing material is less likely to fall off from the first joint surface 77 and the second joint surface 78. When the cooling plate portion 7 is joined to the first lid portion 8 and the second lid portion 9 by welding, the welding direction does not need to be directed in the longitudinal direction L. Accordingly, manufacturing cost can be reduced.

In the cooler 1, since the first joint surface 77 has the inclined surface directed in the second height direction H2 as it goes toward the first longitudinal direction L1, the first joint surface 77 can be directed further toward the first height direction H1 than toward the first longitudinal direction L1 in the portion of the first joint surface 77 displaced in the height direction H. In addition, since the second joint surface 78 has the inclined surface directed in the second height direction H2 as it goes toward the second longitudinal direction L2, the second joint surface 78 can be directed further toward the first height direction H1 side than toward the second longitudinal direction L2 in the portion of the second joint surface 78 displaced in the height direction H.

In the cooler 1, since the first joint surface 77 and the second joint surface 78 are formed by the horizontal surface and the inclined surface, the second joint surface 78 can be directed further toward the first height direction H1 side than toward the second longitudinal direction L2.

Further, in the cooler 1, since the first joint surface 77 and the second joint surface 78 do not have a vertical surface, when the cooling plate portion 7, the first lid portion 8, and the second lid portion 9 are joined by brazing, the brazing material is less likely to fall off from the first joint surface 77 and the second joint surface 78, and when the cooling plate portion 7, the first lid portion 8, and the second lid portion 9 are joined by welding, it is not necessary to direct the welding direction in the longitudinal direction L.

In the cooler 1, the cooling plate portion 7 has the bottom wall portion 71, the upper wall portion 72, and the pair of side wall portions 73 and 73, and the first joint surface 77 and the second joint surface 78 are formed on the bottom wall portion 71, the upper wall portion 72, and the pair of side wall portions 73 and 73. Therefore, the coolant passage 2 partitioned by the plurality of partition walls 74 can be appropriately formed, and the first opening 75 and the second opening 76 that open the coolant passage 2 can be appropriately closed by the first lid portion 8 and the second lid portion 9.

In the cooler 1, the first joint surface 77 is formed on the upper wall upper surface 72c, the first upper wall end surface 72a, the pair of first side wall end surfaces 73a and 73a, and the bottom wall upper surface 71a, and the second joint surface 78 is formed on the upper wall upper surface 72c, the second upper wall end surface 72b, the pair of second side wall end surfaces 73b and 73b, and the bottom wall upper surface 71a. The first joint surface 77 and the second joint surface 78 formed on the upper wall upper surface 72c and the bottom wall upper surface 71a are horizontal surfaces extending in the longitudinal direction L and the width direction W. The first joint surface 77 formed on the first upper wall end surface 72a and the pair of first side wall end surfaces 73a and 73a and the second joint surface 78 formed on the second upper wall end surface 72b and the pair of second side wall end surfaces 73b and 73b are inclined surfaces directed in the second height direction H2 as it goes toward the first longitudinal direction L1. Therefore, the first joint surface 77 and the second joint surface 78 can be directed further toward the first height direction H1 side than toward the second longitudinal direction L2.

In the cooler 1, the first partition wall end surfaces 74a are formed at the same positions as the first side wall end surfaces 73a and 73a when viewed from the width direction W, and the second partition wall end surfaces 74b are formed at the same positions as the second side wall end surfaces 73b and 73b when viewed from the width direction W. Therefore, the cooling plate portion 7 can be easily manufactured.

In the cooler 1, since the first partition wall end surfaces 74a and the second partition wall end surfaces 74b are inclined surfaces, the opening area of the partitioned coolant passages 21 formed by partitioning the coolant passage 2 by the plurality of partition walls 74 can be increased. As a result, a pressure loss of the coolant can be reduced. In addition, it is possible to suppress a rapid change in the pressure loss of the coolant due to the plurality of partition walls 74.

In the cooler 1, the first attachment portion 5 is located on the opposite side of the coolant passage 2 with respect to the first joint surface 77, and the second attachment portion 6 is located on the opposite side of the coolant passage 2 with respect to the second joint surface 78. Therefore, it is possible to suppress blocking of the coolant passage 2 from being obstructed by the first attachment portion 5 and the second attachment portion 6, and it is possible to suppress the first joint surface 77 and the second joint surface 78 from being complicated in shape.

### [Second Embodiment]

Next, a second embodiment will be described. The second embodiment is basically similar to the first embodiment. Therefore, in the following description, only matters different from those of the first embodiment will be described, and the same description as that of the first embodiment will be omitted.

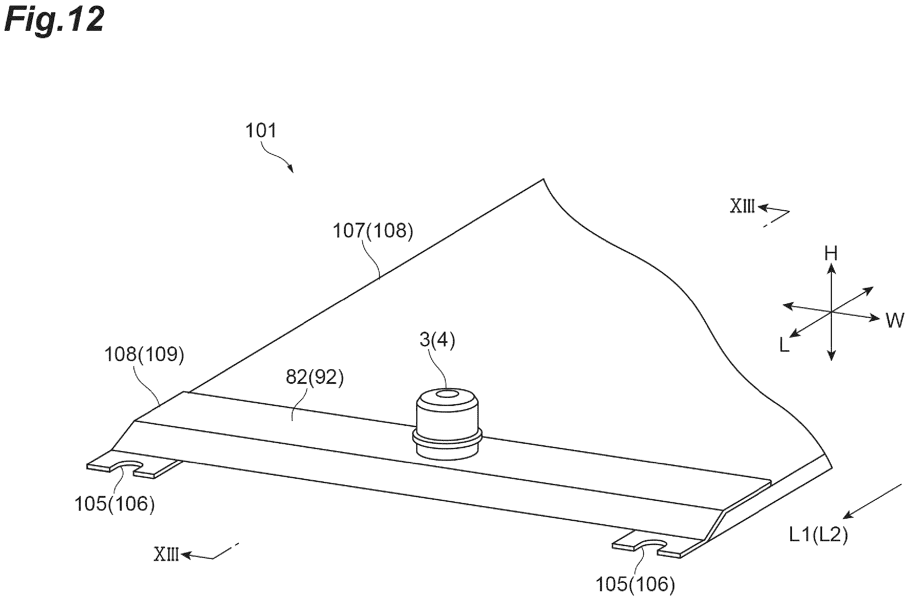

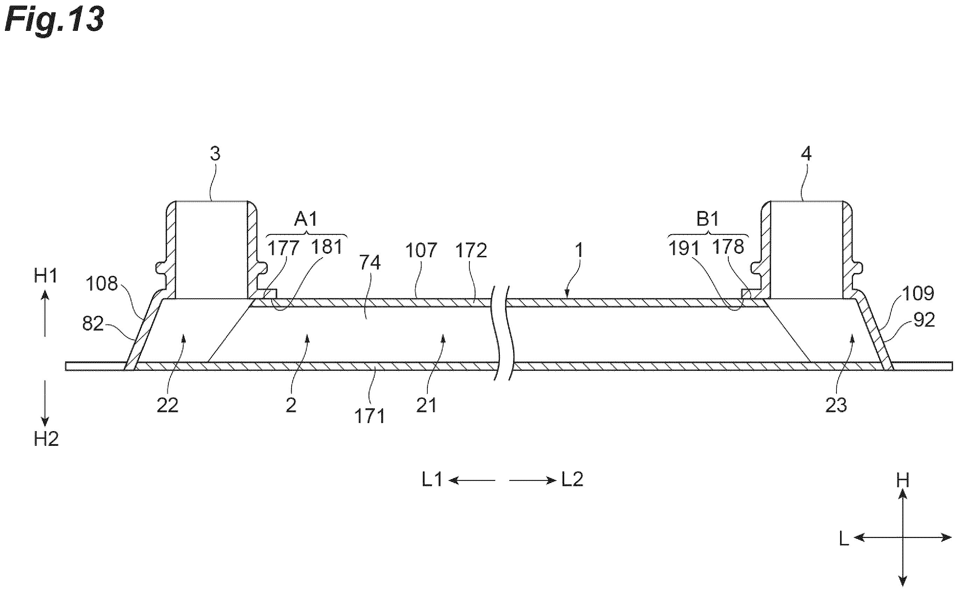

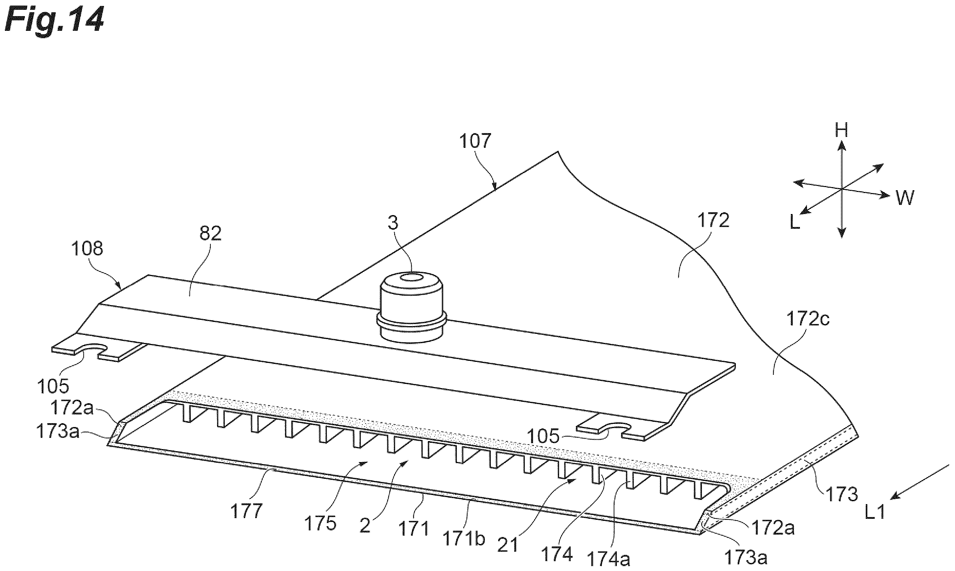

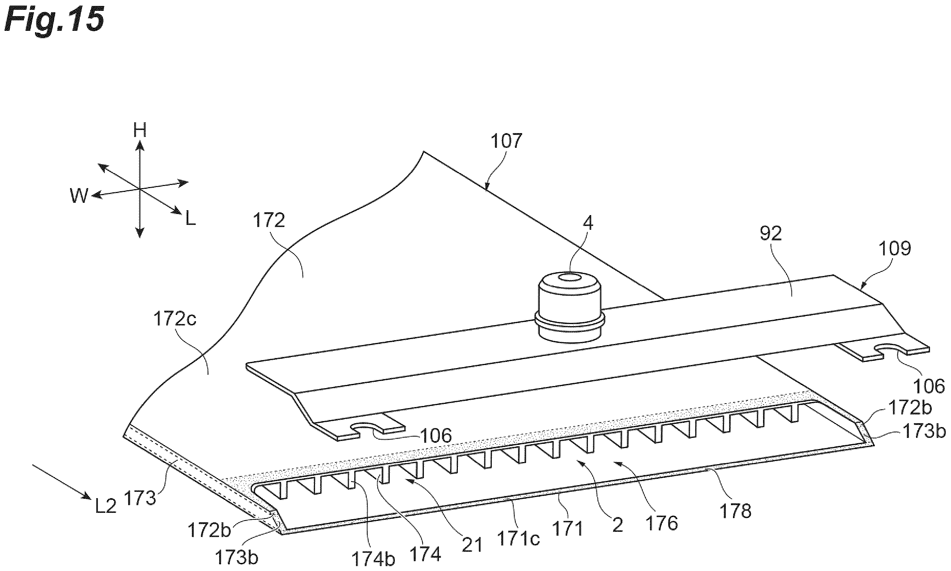

FIG. 12 is a perspective view illustrating an end portion of a cooler according to the second embodiment in the first longitudinal direction and the second longitudinal direction. FIG. 13 is a cross-sectional view taken along line XIII-XIII illustrated in FIG. 12. FIG. 14 is a perspective view illustrating a state of the end portion of the cooler in the first longitudinal direction, before the cooling plate portion and the lid portion are joined to each other. FIG. 15 is a perspective view illustrating a state of the end portion of the cooler in the second longitudinal direction, before the cooling plate portion and the lid portion are joined to each other. As illustrated in FIGS. 12 to 15, a cooler 101 according to the second embodiment includes a coolant passage 2, a first port 3, a second port 4, first attachment portions 105, and second attachment portions 106. The first attachment portion 105 and the second attachment portion 106 correspond to the first attachment portion 5 and the second attachment portion 6 of the first embodiment. The cooler 101 includes a cooling plate portion 107, and first lid portions 108 and second lid portions 109 joined to the cooling plate portion 107. The cooling plate portion 107, the first lid portion 108, and the second lid portion 109 correspond to the cooling plate portion 7, the first lid portion 8, and the second lid portion 9 of the first embodiment.

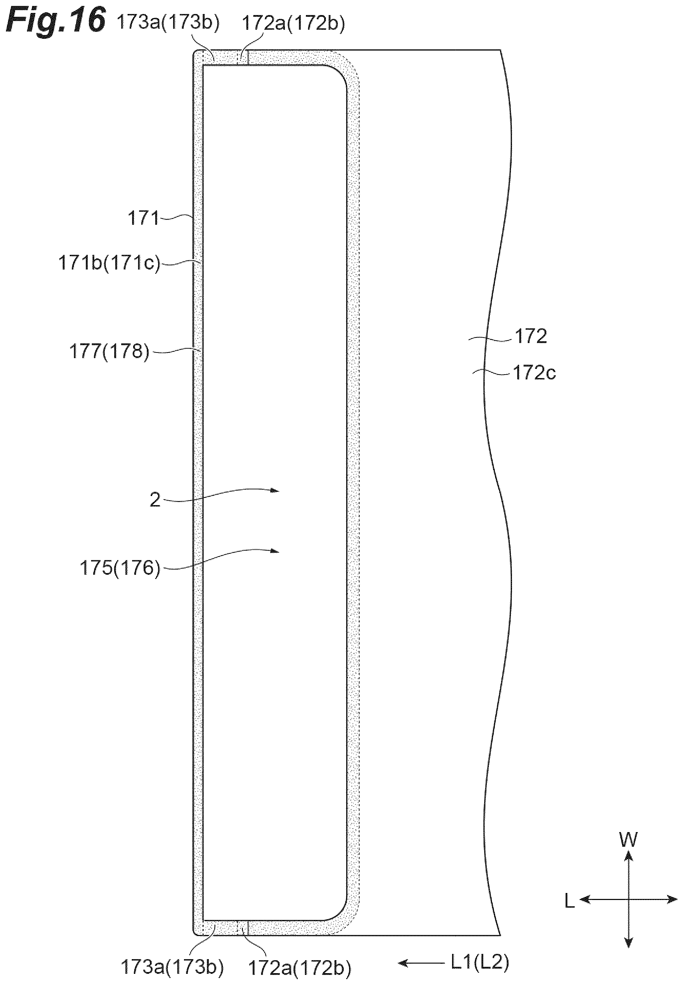

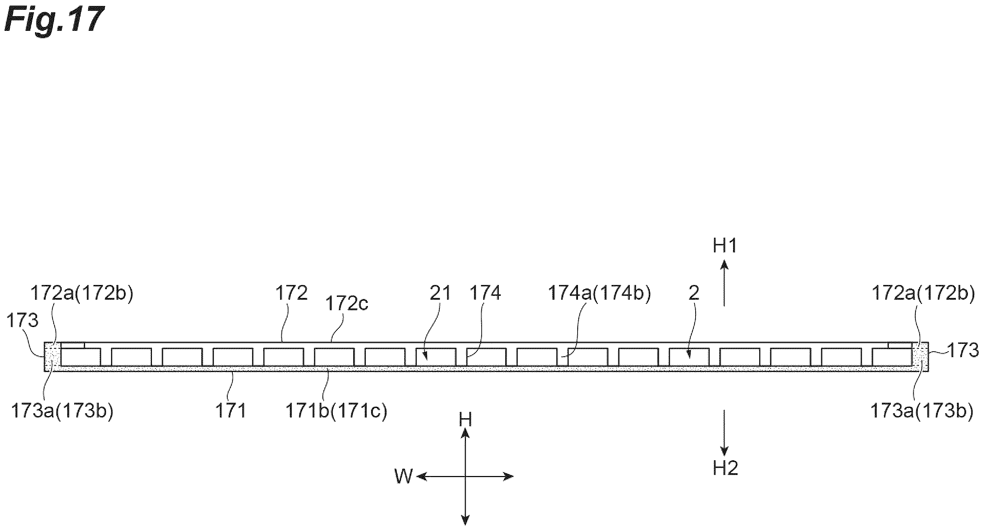

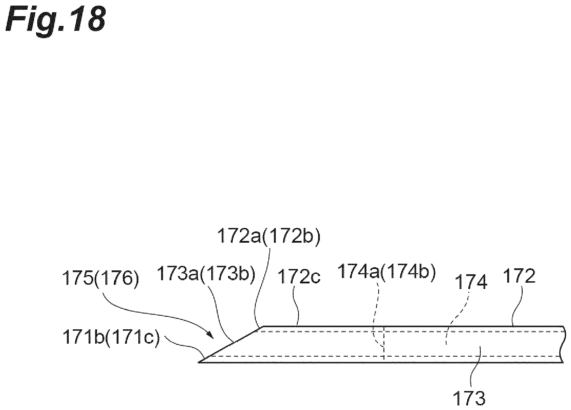

FIG. 16 is a plan view illustrating the end portion of the cooling plate portion in the first longitudinal direction and the second longitudinal direction. FIG. 17 is a front view illustrating the end portion of the cooling plate portion in the first longitudinal direction and the second longitudinal direction. FIG. 18 is a side view illustrating the end portion of the cooling plate portion in the first longitudinal direction and the second longitudinal direction. Note that reference numerals in parentheses in FIGS. 16 to 18 indicate reference numerals of end portions of the cooling plate portion in the second longitudinal direction. As illustrated in FIGS. 12 to 18, the cooling plate portion 107 includes a bottom wall portion 171, an upper wall portion 172, a pair of side wall portions 173 and 173, a plurality of partition walls 174, a first opening 175, and a second opening 176. The bottom wall portion 171, the upper wall portion 172, the pair of side wall portions 173 and 173, the plurality of partition walls 174, the first opening 175, and the second opening 176 correspond to the bottom wall portion 71, the upper wall portion 72, the pair of side wall portions 73 and 73, the plurality of partition walls 74, the first opening 75, and the second opening 76 of the first embodiment.

The first attachment portion 105 is formed only in the first lid portion 108, and is not formed in the cooling plate portion 107. The second attachment portion 106 is formed only in the second lid portion 109, and is not formed in the cooling plate portion 107.

Similarly to the first opening 75 of the first embodiment, the first opening 175 opens the coolant passage 2 in the first longitudinal direction L1 and the first height direction H1 at an end portion of the cooling plate portion 107 in the first longitudinal direction L1. Similarly to the second opening 76 of the first embodiment, the second opening 176 opens the coolant passage 2 in the second longitudinal direction L2 and the first height direction H1 at an end portion of the cooling plate portion 107 in the second longitudinal direction L2.

As illustrated in FIGS. 12 to 14 and 16 to 18, the first lid portion 108 is joined to the cooling plate portion 107 so as to close the first opening 175. A portion where the cooling plate portion 107 and the first lid portion 108 are joined is referred to as a first joint portion A1. At the first joint portion A1, a first joint surface 177 of the cooling plate portion 107 and a joint surface 181 of the first lid portion 108 are joined. The first joint surface 177 is a joint surface of the cooling plate portion 107 with the first lid portion 108, and does not include a surface not joined with the first lid portion 108. The joint surface 181 is a joint surface of the first lid portion 108 with the cooling plate portion 107, and does not include a surface not joined with the cooling plate portion 107. Joining of the first lid portion 108 to the cooling plate portion 107 is not particularly limited, but can be performed by, for example, brazing, welding, or the like.

The first lid portion 108 has the first port 3 described above and a chamber forming portion 82. The first attachment portion 105 is formed at an end portion of the first lid portion 108 in the first longitudinal direction L1.

The joint surface 181 of the first lid portion 108 surrounds the chamber forming portion 82 in order to close the first opening 175. The joint surface 181 has a shape corresponding to the first joint surface 77 of the cooling plate portion 107, that is, a shape along the first joint surface 177 of the cooling plate portion 107.

The first joint surface 177 of the cooling plate portion 107 surrounds the first opening 175 in order to close the first opening 175. The first joint surface 177 is formed on an upper wall upper surface 172c which is a surface of the upper wall portion 172 on a side (first height direction H1 side) opposite to the bottom wall portion 71, first upper wall end surfaces 172a which are end surfaces of the upper wall portion 172 in the first longitudinal direction L1, first side wall end surfaces 173a and 173a which are end surfaces of the pair of side wall portions 173 and 173 in the first longitudinal direction L1, and a first bottom wall end surface 171b which is an end surface of the bottom wall portion 171 in the first longitudinal direction L1. The first joint surface 177 is formed by a horizontal surface extending in the longitudinal direction L and the width direction W and an inclined surface directed in the second height direction H2 as it goes toward the first longitudinal direction L1, and does not have a vertical surface extending in the height direction H. Therefore, the first joint surface 177 is directed further toward the first height direction H1 side (the upper wall portion 172 side with respect to the bottom wall portion 171) than toward the longitudinal direction L. That is, the entire first joint surface 177 surrounding the first opening 175 is directed further toward the first height direction H1 side than toward the longitudinal direction L. In addition, the first joint surface 177 is directed further toward the first height direction H1 side than toward the longitudinal direction L and goes around the first opening 175 when viewed from the first height direction H1 (surrounds an entire circumference of the first opening 175 when viewed from the first height direction H1). Note that the inclined surface is not limited to an inclined surface extending in a planar shape, and may be an inclined surface that is inclined while being bent at one or a plurality of places, or may be an inclined surface that is inclined while being curved.

More specifically, the upper wall upper surface 172c is a horizontal surface extending in the longitudinal direction L and the width direction W. The first upper wall end surface 172a is an inclined surface directed in the second height direction H2 as it goes toward the first longitudinal direction L1. The first side wall end surfaces 173a and 173a are coupled to the first upper wall end surface 172a and the first bottom wall end surface 171b, and are inclined surfaces directed in the second height direction H2 as it goes toward the first longitudinal direction L1. The first bottom wall end surface 171b is an inclined surface directed in the second height direction H2 as it goes toward the first longitudinal direction L1. An inclination angle of the first upper wall end surface 172a, an inclination angle of the first side wall end surfaces 173a and 173a, and an inclination angle of the first bottom wall end surface 171b can be the same. In this case, the first upper wall end surface 172a, the first side wall end surfaces 173a and 173a, and the first bottom wall end surface 171b are flush with each other.

First partition wall end surfaces 174a which are end surfaces of the plurality of partition walls 174 in the first longitudinal direction L1 are vertical surfaces extending in the height direction H. The first partition wall end surfaces 174a are located on the second longitudinal direction L2 side with respect to the first side wall end surfaces 173a and 173a when viewed from the width direction W.

The first joint surface 177 of the cooling plate portion 107 is formed on the upper wall upper surface 172c which is a horizontal surface, the first upper wall end surface 172a which is an inclined surface, the first side wall end surfaces 173a and 173a which are inclined surfaces, and the first bottom wall end surface 171b which is an inclined surface.

As illustrated in FIGS. 12, 13, and 15 to 18, the second lid portion 109 is joined to the cooling plate portion 107 so as to close the second opening 176. A portion where the cooling plate portion 107 and the second lid portion 109 are joined is referred to as a second joint portion B 1. The cooling plate portion 107 and the second lid portion 109 are joined at the second joint portion B1. In the second joint portion B1, a second joint surface 178 of the cooling plate portion 107 and a joint surface 191 of the second lid portion 109 are joined. The second joint surface 178 is a joint surface of the cooling plate portion 107 with the second lid portion 109, and does not include a surface not joined with the second lid portion 109. The joint surface 191 is a joint surface of the second lid portion 109 with the cooling plate portion 107, and does not include a surface not joined with the cooling plate portion 107. Joining of the second lid portion 109 to the cooling plate portion 107 is not particularly limited, but can be performed by, for example, brazing, welding, or the like.

The second lid portion 109 has the second port 4 described above and a chamber forming portion 92. The second attachment portion 106 is formed at an end portion of the second lid portion 109 in the second longitudinal direction L2.

The joint surface 191 of the second lid portion 109 surrounds the chamber forming portion 92 in order to close the second opening 176. The joint surface 191 has a shape corresponding to the second joint surface 178 of the cooling plate portion 107, that is, a shape along the second joint surface 178 of the cooling plate portion 107.

The second joint surface 178 of the cooling plate portion 107 surrounds the second opening 176 in order to close the second opening 176. The second joint surface 178 of the cooling plate portion 107 is formed on the upper wall upper surface 172c, second upper wall end surfaces 172b which are end surfaces of the upper wall portion 172 in the second longitudinal direction L2, second side wall end surfaces 173b and 173b which are end surfaces of the pair of side wall portions 173 and 173 in the second longitudinal direction L2, and a second bottom wall end surface 171c which is an end surface of the bottom wall portion 171 in the second longitudinal direction L2. The second joint surface 178 is formed by a horizontal surface extending in the longitudinal direction L and the width direction W and an inclined surface directed in the second height direction H2 as it goes toward the second longitudinal direction L2, and does not have a vertical surface extending in the height direction H. Therefore, the second joint surface 178 is directed further toward the first height direction H1 side than toward the longitudinal direction L. That is, the entire second joint surface 178 surrounding the second opening 176 is directed further toward the first height direction H1 side than toward the longitudinal direction L. In addition, the second joint surface 178 is directed further toward the first height direction H1 side than toward the longitudinal direction L and goes around the second opening 176 when viewed from the first height direction H1 (surrounds an entire circumference of the second opening 176 when viewed from the first height direction H1).

More specifically, the upper wall upper surface 172c is a horizontal surface extending in the longitudinal direction L and the width direction W. The second upper wall end surface 172b is an inclined surface directed in the second height direction H2 as it goes toward the second longitudinal direction L2. The second side wall end surfaces 173b and 173b are coupled to the second upper wall end surfaces 172b and the second bottom wall end surface 171c, and are inclined surfaces directed in the second height direction H2 as it goes toward the second longitudinal direction L2. The second bottom wall end surface 171c is an inclined surface directed in the second height direction H2 as it goes toward the first longitudinal direction L1. An inclination angle of the second upper wall end surface 172b, an inclination angle of the second side wall end surfaces 173b and 173b, and an inclination angle of the second bottom wall end surface 171c can be the same. In this case, the second upper wall end surface 172b, the second side wall end surfaces 173b and 173b, and the second bottom wall end surface 171c are flush with each other.

Second partition wall end surfaces 174b which are end surfaces of the plurality of partition walls 174 in the second longitudinal direction L2 are vertical surfaces extending in the height direction H. The second partition wall end surfaces 174b are located on the first longitudinal direction L1 side with respect to the pair of second side wall end surfaces 173b and 173b when viewed from the width direction W.

The second joint surface 178 of the cooling plate portion 107 is formed on the upper wall upper surface 172c which is a horizontal surface, the second upper wall end surface 172b which is an inclined surface, the second side wall end surfaces 173b and 173b which are inclined surfaces, and the second bottom wall end surface 171c which is an inclined surface.

As described above, in the cooler 101 according to the present embodiment, the first joint surface 177 is formed on the upper wall upper surface 172c, the first upper wall end surface 172a, the pair of first side wall end surfaces 173a and 173a, and the first bottom wall end surface 171b, and the second joint surface 178 is formed on the upper wall upper surface 172c, the second upper wall end surface 172b, the pair of second side wall end surfaces 173b and 173b, and the second bottom wall end surface 171c. The first joint surface 177 and the second joint surface 178 formed on the upper wall upper surface 172c are horizontal surfaces extending in the longitudinal direction L and the width direction W. The first joint surface 177 formed on the first upper wall end surface 172a, the pair of first side wall end surfaces 173a and 173a, and the first bottom wall end surface 171b and the second joint surface 178 formed on the second upper wall end surface 172b, the pair of second side wall end surfaces 173b and 173b, and the second bottom wall end surface 171c are inclined surfaces directed in the second height direction H2 as it goes toward the first longitudinal direction L1. Therefore, the first joint surface 177 and the second joint surface 178 can be directed further toward the first height direction H1 side than toward the second longitudinal direction L2.

### [Third Embodiment]

Next, a third embodiment will be described. The third embodiment is basically similar to the first embodiment. Therefore, in the following description, only matters different from those of the first embodiment will be described, and the same description as that of the first embodiment will be omitted.

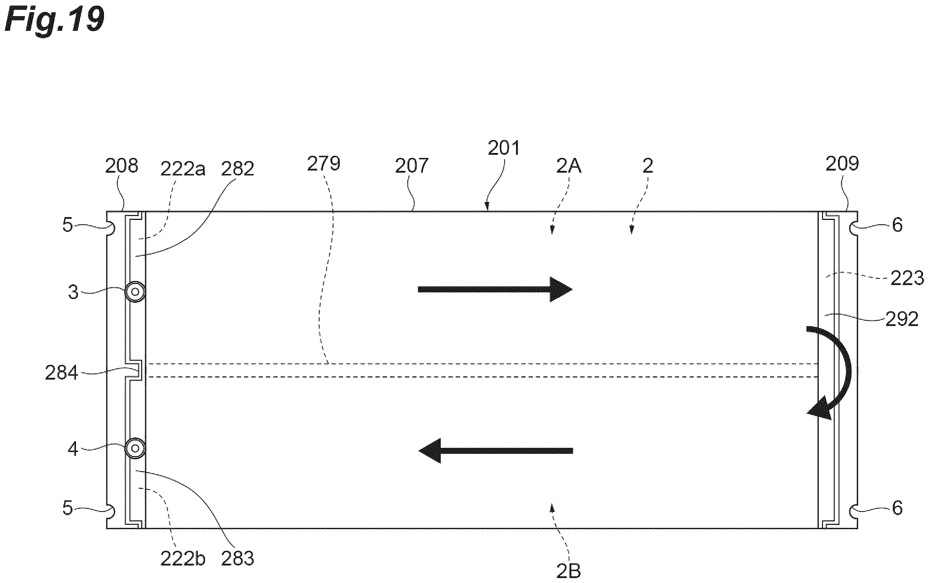

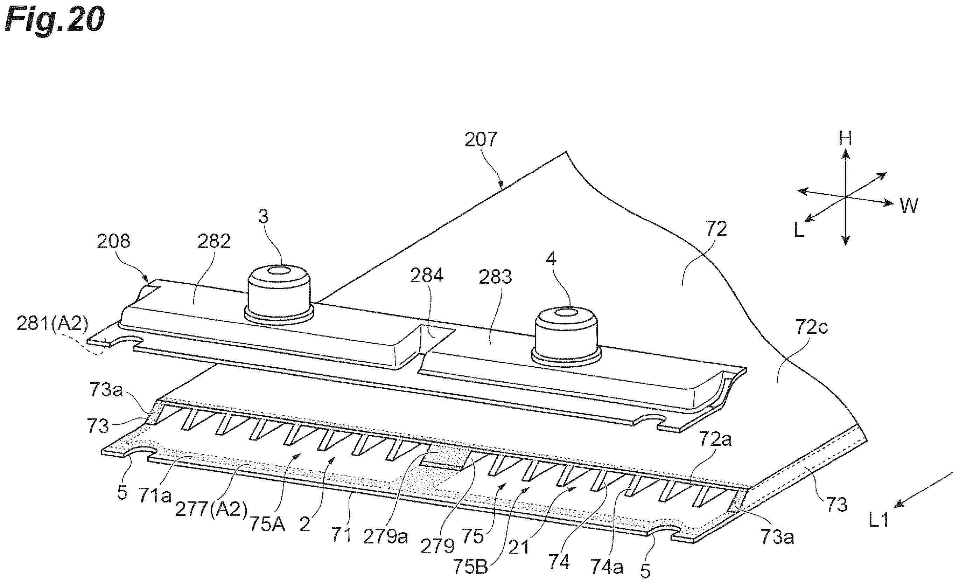

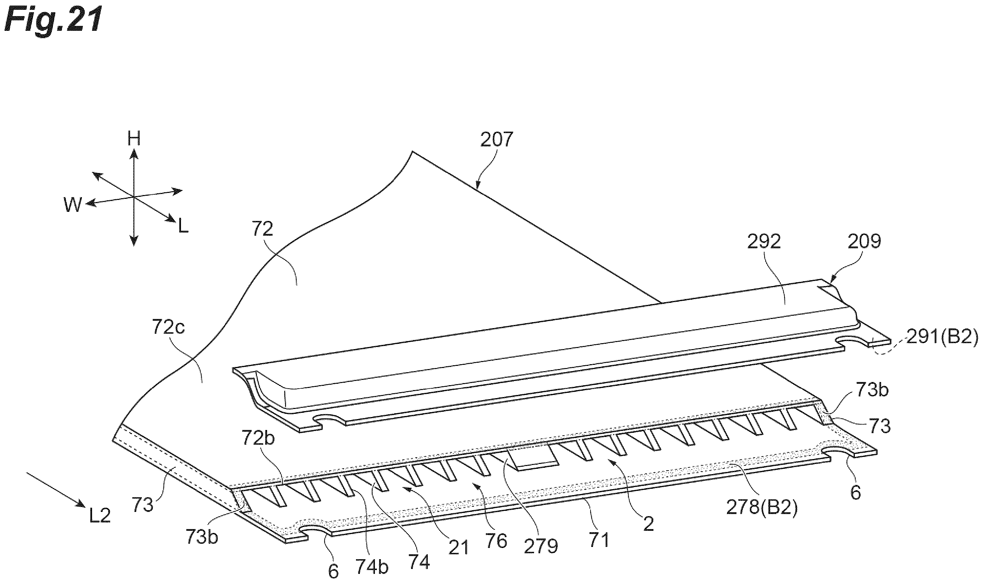

FIG. 19 is a plan view illustrating a cooler of a third embodiment. FIG. 20 is a perspective view illustrating a state of the end portion of the cooler in the first longitudinal direction, before the cooling plate portion and the lid portion are joined to each other. FIG. 21 is a perspective view illustrating a state of the end portion of the cooler in the second longitudinal direction, before the cooling plate portion and the lid portion are joined to each other. As illustrated in FIGS. 19 to 21, a cooler 201 of the third embodiment includes a coolant passage 2, a first port 3, a second port 4, first attachment portions 5, and second attachment portions 6. The cooler 201 includes a cooling plate portion 207, and first lid portions 208 and second lid portions 209 joined to the cooling plate portion 207. The cooling plate portion 207, the first lid portion 208, and the second lid portion 209 correspond to the cooling plate portion 7, the first lid portion 8, and the second lid portion 9 of the first embodiment.

The cooling plate portion 207 includes a bottom wall portion 71, an upper wall portion 72, a pair of side wall portions 73 and 73, a plurality of partition walls 74, a first opening 75, a second opening 76, and a separation wall 279.

The separation wall 279 extends in the longitudinal direction L to separate the coolant passage 2 into a first coolant passage 2A and a second coolant passage 2B in the width direction W. The separation wall 279 is located at the center of the cooling plate portion 207 in the width direction W. Similarly to the plurality of partition walls 74, the separation wall 279 is formed in a substantially flat plate shape extending in the longitudinal direction L and the height direction H, and is coupled to the bottom wall portion 71 and the upper wall portion 72. Of the first opening 75, an opening of the first coolant passage 2A on the first longitudinal direction L1 side is referred to as a first separation opening 75A, and an opening of the second coolant passage 2B on the second longitudinal direction L2 side is referred to as a second separation opening 75B.

A first separation wall end surface 279a which is an end surface of the separation wall 279 in the first longitudinal direction L1 is an inclined surface directed in the second height direction H2 side as it goes toward the first longitudinal direction L1. The first separation wall end surface 279a is formed at the same position as the first side wall end surfaces 73a and 73a when viewed from the width direction W. That is, an inclination angle of the first separation wall end surface 279a is the same as an inclination angle of the first side wall end surfaces 73a and 73a. A second separation wall end surface (not illustrated) which is an end surface of the separation wall 279 in the second longitudinal direction L2 is an inclined surface directed in the second height direction H2 side as it goes toward the second longitudinal direction L2. The second separation wall end surface is formed at the same position as the second side wall end surfaces 73b and 73b when viewed from the width direction W. That is, an inclination angle of the second separation wall end surface is the same as an inclination angle of the second side wall end surfaces 73b and 73b.

The plurality of partition walls 74 are arranged in the width direction W in each of the first coolant passage 2A and the second coolant passage 2B separated in the width direction W by the separation wall 279. Of the plurality of partitioned coolant passages 21 disposed in the first coolant passage 2A and the second coolant passage 2B, the partitioned coolant passage 21 (partitioned coolant passage 21 adjacent to the separation wall 279) located at the end on the separation wall 279 side is formed by the bottom wall portion 71, the upper wall portion 72, the partition wall 74, and the separation wall 279.

The first lid portion 208 is joined to the cooling plate portion 207 so as to close the first opening 75. A portion where the cooling plate portion 207 and the first lid portion 208 are joined is referred to as a first joint portion A2. At the first joint portion A2, a first joint surface 277 of the cooling plate portion 207 and a joint surface 281 of the first lid portion 208 are joined. The first joint surface 277 is a joint surface of the cooling plate portion 207 with the first lid portion 208, and does not include a surface not joined with the first lid portion 208. The joint surface 281 is a joint surface of the first lid portion 208 with the cooling plate portion 207, and does not include a surface not joined with the cooling plate portion 207. Joining of the first lid portion 208 to the cooling plate portion 207 is not particularly limited, but can be performed by, for example, brazing, welding, or the like.

The first lid portion 208 has the first port 3 described above, the second port 4 described above, a first chamber forming portion 282, a second chamber forming portion 283, and a coolant passage separation portion 284.

The first port 3 is provided in the first chamber forming portion 282, and the second port 4 is provided in the second chamber forming portion 283. The first chamber forming portion 282 forms a first chamber 222a disposed between the first port 3 and the first coolant passage 2A. The first chamber 222a is a space that is located on the first longitudinal direction L1 side of the first coolant passage 2A, communicates with the plurality of partitioned coolant passages 21 arranged in the first coolant passage 2A, and communicates with the first port 3. The second chamber forming portion 283 forms a second chamber 222b disposed between the second port 4 and the second coolant passage 2B. The second chamber 222b is a space that is located on the first longitudinal direction L1 side of the second coolant passage 2B, communicates with the plurality of partitioned coolant passages 21 arranged in the second coolant passage 2B, and communicates with the second port 4. The coolant passage separation portion 284 is joined to the cooling plate portion 207 at the first joint portion A2 to separate the first chamber 222a and the second chamber 222b.

The first joint surface 277 of the cooling plate portion 207 surrounds the first opening 75 and surrounds each of the first separation opening 75A and the second separation opening 75B in order to close the first opening 75. The first joint surface 277 is formed on the upper wall upper surface 72c, the first upper wall end surface 72a, the first side wall end surfaces 73a and 73a, the bottom wall upper surface 71a, and the first separation wall end surface 279a. The first joint surface 277 is formed by a horizontal surface extending in the longitudinal direction L and the width direction W and an inclined surface directed in the second height direction H2 as it goes toward the first longitudinal direction L1, and does not have a vertical surface extending in the height direction H. Therefore, the first joint surface 277 is directed further toward the first height direction H1 side (the upper wall portion 72 side with respect to the bottom wall portion 71) than toward the longitudinal direction L. That is, the entire first joint surface 277 surrounding the first opening 75 and surrounding each of the first separation opening 75A and the second separation opening 75B is directed further toward the first height direction H1 side than toward the longitudinal direction L. In addition, the first joint surface 277 is directed further toward the first height direction H1 side than toward the longitudinal direction L, goes around the first opening 75 when viewed from the first height direction H1, and goes around each of the first separation opening 75A and the second separation opening 75B (surrounds the entire circumference of the first opening 75 when viewed from the first height direction H1, and surrounds an entire circumference of each of the first separation opening 75A and the second separation opening 75B).

Specifically, the first separation wall end surface 279a is coupled to the first upper wall end surface 72a and the bottom wall upper surface 71a, and is an inclined surface directed in the second height direction H2 as it goes toward the first longitudinal direction L1. An inclination angle of the first upper wall end surface 72a, an inclination angle of the first side wall end surfaces 73a and 73a, and an inclination angle of the first separation wall end surface 279a can be the same. In this case, the first upper wall end surface 72a, the first side wall end surfaces 73a and 73a, and the first separation wall end surface 279a are flush with each other.

The first joint surface 277 of the cooling plate portion 207 is formed on the upper wall upper surface 72c which is a horizontal surface, the first upper wall end surface 72a which is an inclined surface, the first side wall end surfaces 73a and 73a which are inclined surfaces, the bottom wall upper surface 71a which is a horizontal surface, and the first separation wall end surface 279a which is an inclined surface. Therefore, the cooling plate portion 207 and the first lid portion 208 are joined at the first joint portion A2, whereby the first chamber 222a and the second chamber 222b separated from each other are formed.

The second lid portion 209 is joined to the cooling plate portion 207 so as to close the second opening 76. A portion where the cooling plate portion 207 and the second lid portion 209 are joined is referred to as a second joint portion B2. The cooling plate portion 207 and the second lid portion 209 are joined at the second joint portion B2. In the second joint portion B, a second joint surface 278 of the cooling plate portion 207 and a joint surface 291 of the second lid portion 209 are joined. The second joint portion B2, the second joint surface 278, and the joint surface 291 are similar to the second joint portion B, the second joint surface 78, and the joint surface 91 of the first embodiment. Joining of the second lid portion 209 to the cooling plate portion 207 is not particularly limited, but can be performed by, for example, brazing, welding, or the like.

The second lid portion 209 has a chamber forming portion 292, and does not have any of the first port 3 and the second port 4 described above. The chamber forming portion 292 forms a communication chamber 223 that allows the first coolant passage 2A and the second coolant passage 2B to communicate with each other. The communication chamber 223 is a space located on the second longitudinal direction L2 side of the first coolant passage 2A and the second coolant passage 2B and communicated with the plurality of partitioned coolant passages 21 formed in the first coolant passage 2A and the plurality of partitioned coolant passages 21 formed in the second coolant passage 2B.

As described above, in the cooler 201 according to the present embodiment, the coolant passage 2 is separated in the width direction W into the first coolant passage 2A and the second coolant passage 2B by the separation wall 279, and the first chamber 222a and the second chamber 222b are separated by the first joint portion A2 between the cooling plate portion 207 and the first lid portion 208, so that the first port 3 and the second port 4 can be disposed in the same direction in the longitudinal direction L. In addition, a supply direction and a discharge direction of the coolant with respect to the cooler 201 can be the same. As a result, the cooler 201 can be attached even in a place where the coolant can be supplied and discharged only from one side.

Although the embodiments of the present invention have been described above, the present invention is not limited to the above embodiments.

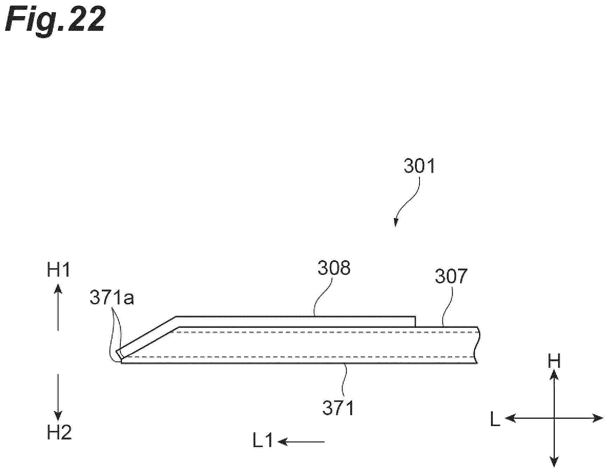

For example, in the above embodiments, in the second embodiment, it has been described that the first side wall end surfaces 173a and 173a, which are end surfaces of the pair of side wall portions 173 and 173 in the first longitudinal direction L1, are inclined surfaces. However, as in a cooler 301 illustrated in FIG. 22, a first bottom wall end surface 371a, which is an end surface of a bottom wall portion 371 of a cooling plate 307 in the first longitudinal direction L1 may be formed by an inclined surface directed in the second height direction H2 as it goes toward the first longitudinal direction L1 and a vertical surface extending in the height direction H. In this case, a first lid portion 308 is joined to the inclined surface of the first bottom wall end surface 371a.

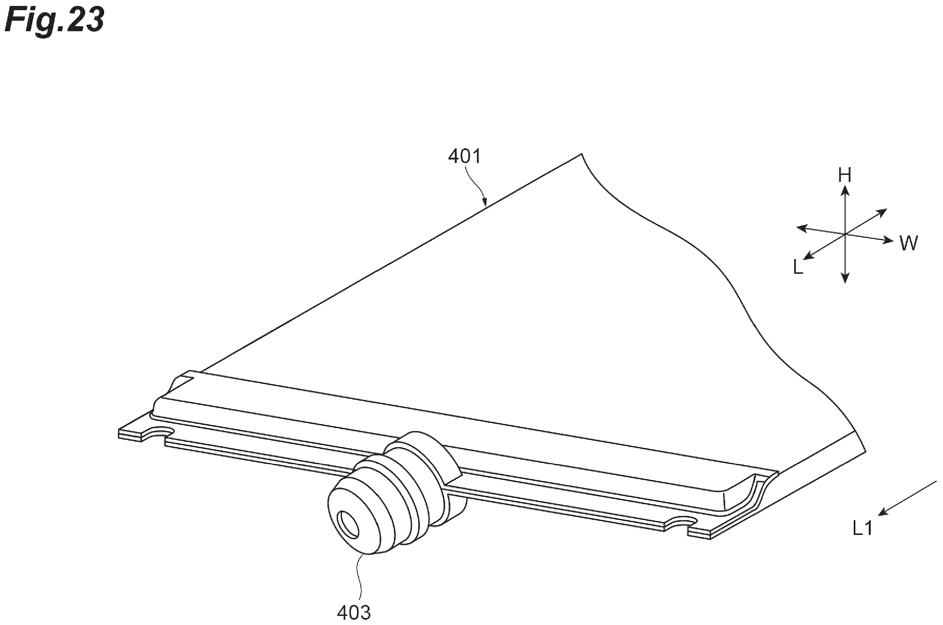

Although the first port 3 and the second port 4 extend in the first height direction H1 in the above embodiment, the direction in which the first port 3 and the second port 4 extend is not particularly limited. Although it is a reference example, in a cooler 401 illustrated in FIG. 23, a first port 403 and a second port (not illustrated) extend along the longitudinal direction L which is the same direction as the extending direction of a partitioned coolant passage (not illustrated).

### Industrial Applicability

One aspect of the present invention can be used as a cooler that cools a battery or the like.

### Reference Signs List

- 1: Cooler
- 2: Coolant passage
- 2A: First coolant passage
- 2B: Second coolant passage
- 3: First port
- 4: Second port
- 5: First attachment portion
- 6: Second attachment portion
- 7: Cooling plate portion
- 8: First lid portion
- 9: Second lid portion
- 21: Partitioned coolant passage
- 22: First chamber
- 23: Second chamber
- 71: Bottom wall portion
- 71a: Bottom wall upper surface
- 72: Upper wall portion
- 72a: First upper wall end surface
- 72b: Second upper wall end surface
- 72c: Upper wall upper surface
- 73: Side wall portion
- 73a: First side wall end surface
- 73b: Second side wall end surface
- 74: Partition wall
- 74a: First partition wall end surface
- 74b: Second partition wall end surface
- 75: First opening
- 75A: First separation opening
- 75B: Second separation opening
- 76: Second opening
- 77: First joint surface
- 78: Second joint surface
- 81: Joint surface
- 82: Chamber forming portion
- 91: Joint surface
- 92: Chamber forming portion
- 101: Cooler
- 105: First attachment portion
- 106: Second attachment portion
- 107: Cooling plate portion
- 108: First lid portion
- 109: Second lid portion
- 171: Bottom wall portion
- 171b: First bottom wall end surface
- 171c: Second bottom wall end surface
- 172: Upper wall portion
- 172a: First upper wall end surface
- 172b: Second upper wall end surface
- 172c: Upper wall upper surface
- 173: Side wall portion
- 173a: First side wall end surface
- 173b: Second side wall end surface
- 174: Partition wall
- 174a: First partition wall end surface
- 174b: Second partition wall end surface
- 175: First opening
- 176: Second opening
- 177: First joint surface
- 178: Second j oint surface
- 181: Joint surface
- 191: Joint surface
- 201: Cooler
- 207: Cooling plate portion
- 208: First lid portion
- 209: Second lid portion
- 222a: First chamber
- 222b: Second chamber
- 223: Communication chamber
- 277: First joint surface
- 278: Second joint surface
- 279: Separation wall
- 279a: First separation wall end surface
- 281: Joint surface
- 282: First chamber forming portion
- 283: Second chamber forming portion
- 284: Coolant passage separation portion
- 291: Joint surface
- 292: Chamber forming portion
- 301: Cooler
- 371: Bottom wall portion
- 371a: First bottom wall end surface
- 401: Cooler
- 403: First port
- A: First j oint portion
- A1: First joint portion
- A2: First j oint portion
- B: Second j oint portion
- B1: Second j oint portion
- B2: Second joint portion
- H: Height direction
- H1: First height direction
- H2: Second height direction
- L: Longitudinal direction
- L1: First longitudinal direction
- L2: Second longitudinal direction
- W: Width direction

## Claims

1. A cooler having a coolant passage, the cooler comprising:
a cooling plate portion having a plurality of partition walls extending in a longitudinal direction and partitioning the coolant passage in a width direction orthogonal to the longitudinal direction, and an opening that opens the coolant passage in a first longitudinal direction which is one direction of the longitudinal direction and a first height direction which is one direction of a height direction orthogonal to the longitudinal direction and the width direction; and
a lid portion joined to the cooling plate portion so as to close the opening of the cooling plate portion, wherein
a joint surface of the cooling plate portion with the lid portion is directed further toward the first height direction side than toward the longitudinal direction.

2. The cooler according to claim 1, wherein
the joint surface has an inclined surface directed in a second height direction opposite to the first height direction as the inclined surface goes toward the first longitudinal direction.

3. The cooler according to claim 2, wherein
the joint surface is formed by a horizontal surface extending in the longitudinal direction and the width direction, and the inclined surface.

4. The cooler according to any one of claims 1 to 3, wherein
the joint surface does not have a vertical surface extending in the height direction.

5. The cooler according to any one of claims 1 to 4, wherein
the cooling plate portion has
a bottom wall portion extending in the longitudinal direction and the width direction,
an upper wall portion extending in the longitudinal direction and the width direction and facing the bottom wall portion in the height direction, and
a pair of side wall portions coupled to the bottom wall portion and the upper wall portion and facing each other in the width direction, and
the joint surface is formed on the bottom wall portion, the upper wall portion, and the pair of side wall portions.

6. The cooler according to claim 5, wherein
the joint surface is formed by
an upper wall upper surface which is a surface of the upper wall portion on a side opposite to the bottom wall portion,
an upper wall end surface which is an end surface of the upper wall portion in the first longitudinal direction,
side wall end surfaces which are end surfaces of the pair of side wall portions in the first longitudinal direction, and
a bottom wall upper surface which is a surface of the bottom wall portion on the upper wall portion side,
the joint surface formed on the upper wall upper surface and the bottom wall upper surface is a horizontal surface extending in the longitudinal direction and the width direction, and
the joint surface formed on the upper wall end surface and the side wall end surfaces is an inclined surface directed in a second height direction opposite to the first height direction as the inclined surface goes toward the first longitudinal direction.

7. The cooler according to claim 5, wherein
the joint surface is formed by
an upper wall upper surface which is a surface of the upper wall portion on a side opposite to the bottom wall portion,
an upper wall end surface which is an end surface of the upper wall portion in the first longitudinal direction,
side wall end surfaces which are end surfaces of the pair of side wall portions in the first longitudinal direction, and
a bottom wall end surface which is an end surface of the bottom wall portion in the first longitudinal direction,
the joint surface formed on the upper wall upper surface is a horizontal surface extending in the longitudinal direction and the width direction, and
the joint surface formed on the upper wall end surface, the side wall end surfaces, and the bottom wall end surface is an inclined surface directed in a second height direction opposite to the first height direction as the inclined surface goes toward the first longitudinal direction.

8. The cooler according to any one of claims 5 to 7, wherein
partition wall end surfaces which are end surfaces of the plurality of partition walls in the first longitudinal direction are formed at same positions as side wall end surfaces which are end surfaces of the pair of side wall portions in the first longitudinal direction when viewed from the width direction.

9. The cooler according to any one of claims 1 to 8, wherein
partition wall end surfaces which are end surfaces of the plurality of partition walls in the first longitudinal direction are inclined surfaces directed in second height direction opposite to the first height direction as the inclined surfaces go toward the first longitudinal direction.

10. The cooler according to any one of claims 1 to 9, further comprising:
an attachment portion for attaching the cooler to an external device, wherein
the attachment portion is located on an opposite side of the coolant passage with respect to the joint surface.
